Europäisches Patentamt

**European Patent Office**

**Office européen des brevets**

(11) Veröffentlichungsnummer: **0 091 397**
**B1**

(19)

(12) **EUROPÄISCHE PATENTSCHRIFT**

(45) Veröffentlichungstag der Patentschrift:
02.07.86

(21) Anmeldenummer: 83730033.4

(22) Anmeldetag: 22.03.83

(51) Int. Cl.⁴: **G 01 R 29/027**, G 01 R 17/02,
H 03 K 3/017, G 01 R 19/165,
G 01 R 35/00

(54) **Messeinrichtung zur genauen Einstellung des Messanfangs eines Messumformers.**

(30) Priorität: 06.04.82 DE 3213329

(43) Veröffentlichungstag der Anmeldung:
12.10.83 Patentblatt 83/41

(45) Bekanntmachung des Hinweises auf die Patenterteilung:
02.07.86 Patentblatt 86/27

(84) Benannte Vertragsstaaten:
AT BE CH DE FR GB IT LI NL

(56) Entgegenhaltungen:
FR-A-2 390 739
US-A-3 626 289
US-A-4 152 675

ELECTRONICS INTERNATIONAL, Band 54, Nr. 7, 7. April 1981, Seiten 158,159, New York, USA M. BURKE: "Chip changes the colors of light-emitting diodes"
WIRELESS WORLD, Band 85, Nr. 1528, Dezember 1979, Seite 60, D.K. HAMILTON: "P.w.m. control"
ELECTRONICS, Band 53, Nr. 2, Januar 1980, Seite 125, New York, USA S. TALMOR: "Autocorrecting driver rights pulse polarity"
ELECTRONICS, Band 51, Nr. 13, Juni 1978, Seite 150, New York, USA W.A. PALM: "Three Leds display response of null-detector circuit"

(73) Patentinhaber: Siemens Aktiengesellschaft, Berlin und München Wittelsbacherplatz 2, D-8000 München 2 (DE)

(72) Erfinder: Schulz, Winfried, Dr. Ing.,
Kurfürstenstrasse 29, D-1000 Berlin 42 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

## Beschreibung

Die Erfindung bezieht sich auf eine Meßeinrichtung zur genauen Einstellung eines durch einen vorgegebenen Gleichstromwert bestimmten Meßanfangs eines Meßumformers in Zwei-Leiter-Ausführung. Für derartige Meßumformer ist bekanntlich festgelegt, daß ihr Meßanfang bei einem Strom von 4 mA liegt. Dieser Meßanfang ist im Hinblick auf die gewünschte Genauigkeit sehr genau mit ± 1 % einzustellen. Wegen der erforderlichen hohen Genauigkeit läßt sich dies mit einem Digitalmultimeter bewerkstelligen; Drehspulzeiger sind nicht einsetzbar. Zur Einstellung des Meßanfangs eines Meßumformers in Zwei-Leiter-Ausführung ist daher bisher stets ein Digitalmultimeter erforderlich, das auch zur Überprüfung des Meßanfangs zur Verfügung stehen muß. Da derartige Meßgeräte verhältnismäßig kostspielig sind, kommt ihre feste Zuordnung zu einem Meßumformer in Zwei-Leiter-Ausführung nicht in Frage.

Der Erfindung liegt die Aufgabenstellung zugrunde, eine Meßeinrichtung zur genauen Einstellung des Meßanfangs eines Meßumformers in Zwei-Leiter-Ausführung vorzuschlagen, die trotz Einhaltung der erforderlichen Genauigkeit einfach aufgebaut und daher kostengünstig herstellbar ist, so daß sie einen festen Bestandteil eines jeden Meßumformers in Zwei-Leiter-Ausführung bilden kann.

Zur Lösung dieser Aufgabe ist bei einer Meßeinrichtung der eingangs angegebenen Art erfindungsgemäß an einen in Reihe mit dem Meßumformer angeordneten Erfassungswiderstand mit seinem Eingang ein Multivibrator angeschlossen, dessen in Abhängigkeit von der Spannung an seinem Eingang sich änderndes Tastverhältnis bei dem dem Meßanfang entsprechenden Strom durch den Erfassungswiderstand 1:1 beträgt, und dem Multivibrator ist eine Anordnung mit zwei Leuchtdioden nachgeordnet, die aus den durch den Meßumformer fließenden Strom speisbar sind und bei dem Tastverhältnis von 1:1 gleich hell aufleuchten.

Ein Vorteil der erfindungsgemäßen Meßeinrichtung besteht darin, daß sie vergleichsweise einfach aufgebaut ist, da sie lediglich aus einem Multivibrator und einer Anordnung mit zwei Leuchtdioden besteht. Die erfindungsgemäße Meßeinrichtung kann daher mit vertretbarem Aufwand jedem Meßumformer in Zwei-Leiter-Ausführung zugeordnet werden. Der einfache Aufbau der erfindungsgemäßen Meßeinrichtung beeinträchtigt nicht ihre Meßgenauigkeit, weil eine Einstellung mit einer Genauigkeit von 1 ‰ ohne Schwierigkeiten erreichbar ist. Dies ist darauf zurückzuführen, daß die genaue Einstellung des Meßanfangs dann bewirkt ist, wenn beide Leuchtdioden gleich hell aufleuchten. Bei der Einstellung des Meßanfangs läßt sich dies durch eine einfache Impulsbreitensteuerung des Multivibrators erreichen. Ein weiterer Vorteil der erfindungsgemäßen Meßeinrichtung besteht darin, daß ihr Spannungsbedarf bei 4 mA unter 3 Volt gehalten werden kann und auch bei 20 mA nur unwesentlich über 3 Volt liegt. Falls dieser Spannungsabfall im Betrieb des Meßumformers als störend empfunden werden sollte, kann nach der Einstellung des Meßanfangs die gesamte Meßeinrichtung durch einen Schaltkontakt überbrückt werden.

Es ist zwar aus der Druckschrift "Electronics International", Band 54, Nr. 7, April 1981, Seite 158f eine Anzeigevorrichtung bekannt, bei der das Tastverhältnis eines Multivibrators durch eine Eingangsspannung steuerbar ist und entsprechend dem Tastverhältnis zwei in verschiedenen Farben leuchtende Elemente einer nachgeordneten integrierten Doppelleuchtdiode angesteuert werden, die in der Mischfarbe ihrer beiden Elemente aufleuchtet; als Meßeinrichtung zur genauen Einstellung des Meßanfangs eines Meßumformers in Zwei-Leiter-Ausführung ist jedoch diese Anzeigevorrichtung nicht geeignet, weil bei ihr wegen der Verwendung einer einzigen mehrfarbigen Doppelleuchtdiode ein Abgleich durch Helligkeitsvergleich nicht möglich ist.

Es ist weiterhin aus der US-PS 3 626 289 eine Schaltung für einen elektronischen Zähler in einer Meßanordnung bekannt, mit der sich die Frequenz eines Wechselstromsignals unbeeinflußt durch eine Gleichkomponente ermitteln läßt. Dabei sind einem Schmitt-Trigger zwei Lampen nachgeordnet, die bei der zu untersuchenden Eingangswechselspannung jeweils derart angesteuert werden sollen daß beide Lampen gleich hell aufleuchten. Zu diesem Zweck wird die Triggerspannung solange verändert, bis beide Lampen gleiche Helligkeit aufweisen. Zu diesem Zustand ist der Einfluß der Gleichstromkomponente auf das Ergebnis der Frequenzmessung eliminiert. Die Einstellung eines vorgegebenen Gleichstromwertes ist bei dieser Schaltung dagegen nicht vorgesehen. Zur genauen Einstellung des Meßanfangs eines Meßumformers ist daher die bekannte Meßanordnung nicht geeignet.

Bei der erfindungsgemäßen Meßeinrichtung liegt vorteilhafterweise in Reihe mit den Leuchtdioden jeweils ein elektronischer Schalter, von denen einer mit seinem Steuereingang mit dem Ausgang des Multivibrators verbunden ist; der Steuereingang des anderen elektronischen Schalters ist mit dem Verbindungspunkt des einen Schalters und der mit ihm in Reihe liegenden Leuchtdiode verbunden, und die Reihenschaltungen der Leuchtdioden und der elektronischen Schalter sind an den Ausgang einer Spannungsstabilisierungsschaltung angeschlossen. Dadurch läßt sich erreichen, daß die Wirkungsweise der erfindungsgemäßen Meßeinrichtung unabhängig davon ist, ob sie mit einem eingeprägten Strom oder über einen variablen Widerstand speisbar ist.

Bei der erfindungsgemäßen Meßeinrichtung wird es ferner als vorteilhaft erachtet, wenn der in Reihe mit dem einen elektronischen Schalter angeordneten Leuchtdiode ein Überbrückungswiderstand parallelgeschaltet ist. Durch diesen Überbrückungswiderstand ist nämlich sichergestellt, daß bei einem Ausfall der einen Leuchtdiode die andere Leuchtdiode nach wie vor arbeiten kann. Trotz Ausfalls einer Leuchtdiode ist dann noch eine relativ genaue Einstellung des Meßanfangs anhand einer halb so großen Helligkeit der noch im Betrieb befindlichen Leuchtdiode möglich.

In Reihe mit dem Erfassungswiderstand liegt bei der erfindungsgemäßen Meßeinrichtung vorteilhafterweise eine Zenerdiode der Spannungsstabilisierung, und der vom Erfassungswiderstand abgewandte Anschlußpunkt der Zenerdiode ist über einen veränderbaren Widerstand mit dem Eingangsanschluß des Multivibrators verbunden, der an den von der Zenerdiode abgewandten Anschlußpunkt des Erfassungswiderstandes geführt ist. Mit diesem veränderbaren Widerstand läßt sich das Tastverhältnis des Multivibrators auf den Wert 1:1 bei 4 mA sehr genau einstellen.

Bei einer anderen, analogen Lösung der oben angegebenen Aufgabe ist an einem in Reihe mit dem Meßumformer angeordneten Erfassungswiderstand mit ihrem Eingang einer Differenzverstärker-Anordnung angeschlossen deren zwei Differenzverstärker im Gegentakt arbeiten; der Differenzverstärker-Anordnung ist eine Anordnung mit zwei Leuchtdioden nachgeschaltet, die von jeweils einem der zwei Differenzverstärker derart steuerbar sind, daß sie bei genauer Einstellung des Meßanfangs gleich hell leuchten. Bei dieser Lösung ist der Multivibrator gewissermaßen durch die beiden Differenzverstärker und in der Anordnung mit den Leuchtdioden die Schalter durch kontinuierlich arbeitende Steuereinrichtungen ersetzt. Auch bei einer derartigen Meßeinrichtung ist der Aufbau im Vergleich zu einem Digitalmultimeter einfach. Auch die Meßgenauigkeit ist hoch, jedoch ist hier auf Temperaturstabilität der Differenzverstärker zu achten.

Es ist zwar aus der Druckschrift "Electronics" vom 22 Juni 1978, Seite 150 ein Nullspannungs-Detektor für eine Meßbrücke bekannt, der ebenfalls eine Differenzverstärker-Anordnung mit zwei im Gegentakt arbeitenden Differenzverstärkern und eine nachgeordnete Anordnung mit Leuchtdioden aufweist, jedoch benötigt diese Anordnung mit zwei den Differenzverstärkern nachgeordneten Leuchtdioden zur Anzeige einer positiven oder negativen Abweichung von der Nullage eine dritte Leuchtdiode, die den abgeglichenen Zustand der Meßbrücke anzeigt; die Anzeigebereiche der einzelnen Leuchtdioden überlappen sich dabei. Auch dieser Nullspannungs-Detektor ist für eine Anwendung als Meßeinrichtung zur genauen Einstellung des Meßanfangs eines Meßumformers in Zwei-Leiter-Ausführung ungeeignet, weil nur die eine Leuchtdiode mehr oder weniger hell aufleuchtet und daher ein Helligkeitsvergleich zur Einstellung des Meßanfangs mit einer Genauigkeit von 1 ‰ nicht möglich ist.

Bei der Ausführungsform der erfindungsgemäßen Meßeinrichtung mit zwei Differenzverstärkern liegt vorteilhafterweise in Reihe mit den Leuchtdioden jeweils eine elektronische Steuereinrichtung, deren Eingänge mit den Ausgängen der Differenzverstärker verbunden sind; die Reihenschaltungen aus jeweils Leuchtdiode und elektronischer Steuereinrichtung sind an eine Stabilisierungsschaltung angeschlossen.

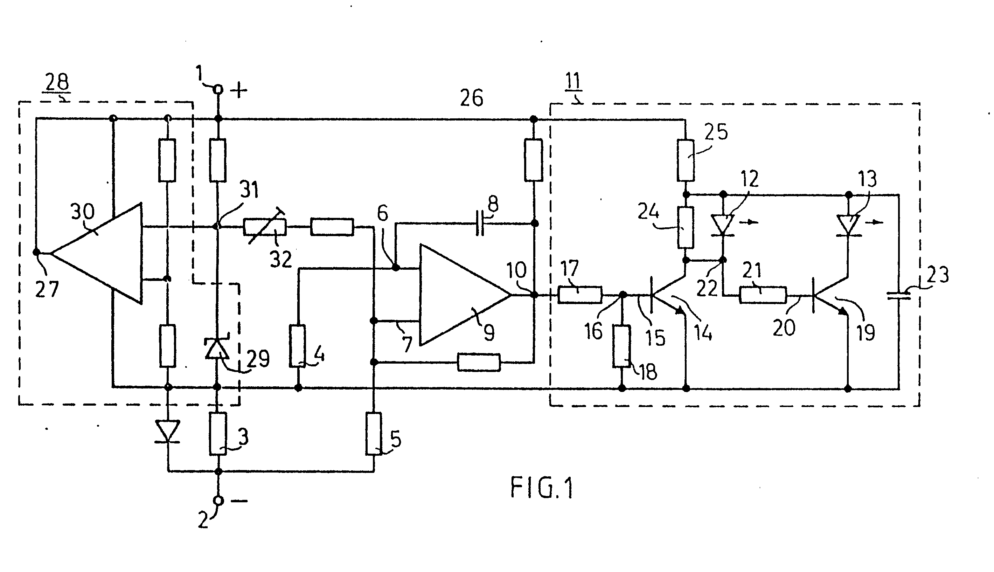

Zur Erläuterung der Erfindung ist in der Figur ein Ausführungsbeispiel der erfindungsgemäßen Meßeinrichtung dargestellt.

Die dargestellte Meßeinrichtung enthält eine Anschlußklemme 1 und eine weitere Anschlußklemme 2, die im Stromkreis des in der Figur nicht dargestellten Meßumformers liegen. Zwischen den beiden Anschlußklemmen 1 und 2 befindet sich ein Erfassungswiderstand 3, der über Widerstände 4 und 5 mit Eingängen 6 und 7 eines über einen Kondensator 8 kapazitiv rückgekoppelten Verstärkers eines Multivibrators 9 verbunden ist.

Am Ausgang 10 des Multivibrators 9 ist eine Anordnung 11 mit zwei Leuchtdioden 12 und 13 angeschlossen, bei denen es sich vorzugsweise um Lumineszenzdioden handelt.

In Reihe mit der einen Leuchtdiode 12 liegt ein elektronischer Schalter 14, der im dargestellten Ausführungsbeispiel von einem Transistor gebildet ist. Der elektronische Schalter 14 liegt mit seinem vom Basis-Anschluß gebildeten Steuereingang 15 an einem Abgriff 16 eines aus Widerständen 17 und 18 gebildeten Spannungsteilers. In Reihe mit der anderen Leuchtdiode 13 ist ein weiterer elektronischer Schalter 19 angeordnet, der ebenfalls als Transistor ausgeführt ist. Sein Steuereingang 20 bzw. Basis-Anschluß ist über einen Widerstand 21 mit einem gemeinsamen Verbindungspunkt 22 der einen Leuchtdiode 12 und des einen elektronischen Schalters 14 verbunden. Parallel zur Reihenschaltung der anderen Leuchtdiode 13 und des weiteren elektronischen Schalters 19 liegt ein Kondensator 23. Parallel zur einen Leuchtdiode 12 ist ein Überbrückungswiderstand 24 angeordnet.

Die Leuchtdioden 12 und 13 sind über einen Widerstand 25 an eine Leitung 26 angeschlossen, die zum Ausgang 27 einer Spannungsstabilisierungsschaltung 28 führt. Diese Spannungsstabilisierungsschaltung 28 enthält eingangsseitig eine Zenerdiode 29, die in Reihe mit dem Erfassungswiderstand 3 zwischen den Anschlußklemmen 1 und 2 der Meßeinrichtung liegt. Mittels dieser Zenerdiode 29 wird eine konstante Spannung erfaßt und in einem nachgeordneten Operationsverstärker 30 auf einen Wert verstärkt, der zum Betrieb des Multivibrators 9 und der Anordnung 11 mit den beiden Leuchtdioden erforderlich ist.

Zur genauen Einstellung des Tastverhältnisses auf den Wert 1:1 beim Meßanfang und damit bei einem Strom von 4 mA ist zwischen dem von dem Erfassungswiderstand 3 abgewandten Anschluß 31 der Zenerdiode 29 und dem Eingang 7 des Multivibrators 9 ein veränderbarer Widerstand 32 angeordnet. Durch diesen Widerstand wird die erfindungsgemäße Meßeinrichtung einmal so eingestellt daß bei einem Strom von 4 mA das Tastverhältnis des Multivibrators 9 1:1 beträgt und beide Leuchtdioden 12 und 13 gleich hell gesteuert sind.

Die beschriebene Meßeinrichtung arbeitet in folgender Weise:

Hat bei der Überprüfung der Einstellung des Meßanfangs der Strom durch den Meßumformer nicht den Wert 4 mA, dann verursacht ein entsprechender Spannungsabfall am Erfassungswiderstand 3 eine derartige Steuerung des Multivibrators 9, daß dessen Tastverhältnis vom Wert 1:1 abweicht. Demzufolge wird beispielsweise die eine Leuchtdiode 12 infolge einer verhältnismäßig langen Öffnungszeit des einen elektronischen Schalters 14 in einem Zyklus verhältnismäßig lange aufleuchten, während die andere Leuchtdiode 13 vergleichsweise kurz aufleuchtet. Dieses jeweils unterschiedlich lange Aufleuchten der beiden Leuchtdioden 12 und 13 wird vom Auge der Bedienungsperson als ein helleres oder ein weniger helles Aufleuchten der Leuchtdioden registriert; das nur impulsweise Aufleuchten der Leuchtdioden 12 und 13 wird vom Auge nicht bemerkt, wenn - wie es vorgesehen ist - die Frequenz des Multivibrators einige kHz beträgt. Durch Änderung des Stromes über die Eingangsklemmen 1 und 2 der Meßeinrichtung läßt sich am Erfassungswiderstand 3 ein derartiger Spannungsabfall einstellen, daß der Multivibrator 9 ein Tastverhältnis von 1:1 erhält. Dann werden die beiden elektronischen Schalter 14 und 19 in einem Zyklus jeweils gleich lange Zeit geöffnet, und die mit ihnen in Reihe liegenden Leuchtdioden 12 und 13 leuchten jeweils gleich lange auf. Das Auge registriert eine gleiche Helligkeit bei beiden Leuchtdioden 12 und 13; der Meßanfang ist damit mit einer Genauigkeit von 1 ‰ eingestellt.

6 Patentansprüche
1 Figur

**Patentansprüche**

1. Meßeinrichtung zur genauen Einstellung eines durch einen vorgegebenen Gleichstromwert bestimmten Meßanfangs eines Meßumformers in Zwei-Leiter-Ausführung, dadurch gekennzeichnet, daß an einem in Reihe mit dem Meßumformer angeordneten Erfassungswiderstand (3) mit seinem Eingang (6, 7) ein Multivibrator (9) angeschlossen ist, dessen in Abhängigkeit von der Spannung an seinem Eingang (6, 7) sich änderndes Tastverhältnis bei dem dem Meßanfang entsprechenden Strom durch den Erfassungswiderstand (3) 1:1 beträgt, und daß dem Multivibrator (9) eine Anordnung (11) mit zwei Leuchtdioden (12, 13) nachgeordnet ist, die aus dem durch den Meßumformer fließenden Strom speisbar sind und bei dem Tastverhältnis von 1:1 gleich hell aufleuchten.

2. Meßeinrichtung nach Anspruch 1, dadurch gekennzeichnet, daß in Reihe mit den Leuchtdioden (12, 13) jeweils ein elektronischer Schalter (14, 19) liegt, von denen einer (14) mit seinem Steuereingang (15) mit dem Ausgang (10) des Multivibrators (9) verbunden ist, daß der Steuereingang (20) des anderen elektronischen Schalters (19) mit dem Verbindungspunkt (22) des einen Schalters (14) und der mit ihm in Reihe liegenden Leuchtdiode (12) verbunden ist und daß die Reihenschaltung der Leuchtdioden (12, 13) und der elektronischen Schalter (14, 19) an den Ausgang (27) einer Spannungsstabilisierungsschaltung (28) angeschlossen sind.

3. Meßeinrichtung nach Anspruch 2, dadurch gekennzeichnet, daß der in Reihe mit dem einen elektronischen Schalter (14) angeordneten Leuchtdiode (12) ein Überbrückungswiderstand (24) parallel geschaltet ist.

4. Meßeinrichtung nach Anspruch 2 oder 3, dadurch gekennzeichnet, daß in Reihe mit dem Erfassungswiderstand (3) eine Zenerdiode (29) der Stabilisierungsschaltung (28) liegt und daß der vom Erfassungswiderstand (3) abgewandte Anschlußpunkt (31) der Zenerdiode (29) über einen veränderbaren Widerstand (32) mit dem Eingangsanschluß (7) des Multivibrators (9) verbunden ist, der an den von der Zenerdiode (29) abgewandten Anschlußpunkt des Erfassungswiderstandes (3) geführt ist.

5. Meßeinrichtung zur genauen Einstellung eines durch einen vorgegebenen Gleichstromwert bestimmten Meßanfangs eines Meßumformers in Zwei-Leiter-Ausführung, dadurch gekennzeichnet, daß an einem in Reihe mit dem Meßumformer angeordneten Erfassungswiderstand mit ihrem Eingang eine Differenzverstärker-Anordnung angeschlossen ist, deren zwei Differenzverstärker im Gegentakt arbeiten, und daß der Differenzverstärker-Anordnung eine Anordnung mit zwei Leuchtdioden nachgeschaltet ist, die von jeweils einem der zwei Differenzverstärker derart steuerbar sind, daß sie bei genauer Einstellung des Meßanfangs gleich hell leuchten.

6. Meßeinrichtung nach Anspruch 5, dadurch gekennzeichnet, daß in Reihe mit den Leuchtdioden jeweils eine elektronische Steuereinrichtung liegt, deren Eingänge mit den Ausgängen der Differenzverstärker verbunden sind, und daß die Reihenschaltungen aus Leuchtdiode und elektronischer Steuereinrichtung jeweils an eine Stabilisierungsschaltung angeschlossen sind.

## Claims

1. A measuring arrangement for exact adjustment of the beginning of the measuring range of a two-wire measuring converter, determined by a predetermined d.c. value, characterized in that a multivibrator (9) has its input (6, 7) connected to a registering resistor (3) connected in series with the measuring converter, and the duty cycle of said multivibrator, which changes in dependence upon the voltage at its input (6, 7), is 1:1 for the current through the registering resistor (3) at the beginning of the measuring range, and that the multivibrator (9) is followed by an arrangement (11) having two lightemitting diodes (12, 13) fed from the current which flows through the measuring converter and illuminated with equal brightness when the duty cycle is 1:1.

2. A measuring device as claimed in Claim 1, characterised in that a respective electronic switch (14, 19) is seriesconnected to each of the diodes (12, 13), one (14) of which switches has its control input (15) connected to the output (10) of the multivibrator (9), that the control input (20) of the other electronic switch (19) is connected to the connecting point (22) of the one switch (14) and to the diode (12) which is connected in series thereto, and that the series combinations of the diodes (12, 13) and the electronic switches (14, 19) are connected to the output (27) of a voltage stabilization circuit (28).

3. A measuring device as claimed in Claim 2, characterized in that a bridging resistor (24) is connected parallel to the diode (12) which is arranged in series to the one electronic switch (14).

4. A measuring device as claimed in Claim 2 or 3, characterized in that a Zener diode (29) of the stabilisation circuit (28) is series-connected to the registering resistor (3) and that the terminal point (31) of the Zener diode (29) remote from the registering resistor (3) is connected via a variable resistor (32) to the input terminal (7) of the multivibrator (9), which leads to the terminal point of the registering resistor (3) remote from the Zener diode (29).

5. A measuring device for the exact positioning of the beginning of the measuring range of a two-wire measuring converter, determined by a predetermined d.c. value, characterized in that a difference amplifier arrangement has its input connected to a registering resistor seriesconnected to the measuring converter, the two difference amplifiers of which difference amplifier arrangement operate in a push-pull mode, and that the difference amplifier arrangement is followed by an arrangement with two lightemitting diodes which are respectively controllable by one of the two difference amplifiers in such a manner that they are illuminated with equal brightness when the beginning of the measuring range is accurately adjusted.

6. A measuring device as claimed in Claim 5, characterrized in that a respective electronic control device is arranged in series with each diode, that inputs of which control device are connected to the outputs of the difference amplifiers, and that the series combinations of diode and electronic control device are respectively connected to a stabilisation circuit.

## Revendications

1. Dispositif de mesure servant à réaliser le réglage précis du début de la plage de mesure, déterminé par une valeur de courant continu prédéterminée, d'un convertisseur de mesure du type à deux conducteurs, caractérisé par le fait qu'à une résistance de détection (3) branchée en série avec le convertisseur de mesure se trouve raccordée une entrée (6, 7) d'un multivibrateur (9) dont le taux d'impulsions, qui varie en fonction de la tension présente sur son entrée (5, 7), est égal à 1:1 pour le courant correspondant au début de la plage de mesure et traversant la résistance de détection (3), et qu'en aval du multivibrateur (9) se trouve monté un dispositif (11) comportant deux diodes lumineuses (12, 13), qui peuvent être alimentées par le courant circulant à travers le convertisseur de mesure et qui éclaire avec une même luminosité dans le cas du taux d'impulsions égal à 1:1.

2. Dispositif de mesure selon la revendication 1, caractérisé par le fait qu'en série avec les diodes lumineuses (12, 13) se trouvent branchés respectivement des commutateurs électroniques (14, 19), dont l'un (14) est relié par son entrée de commande (15) à la sortie (10) du multivibrateur (9), que la sortie de commande (20) de l'autre commutateur électronique (19) est reliée au point de jonction (22) du premier commutateur (14) et de la diode lumineuse (12) branchée en série avec ce commutateur, et que le circuit série formé des diodes lumineuses (12, 13) et des commutateurs électroniques (14, 19) est raccordée à la sortie (27) d'un circuit stabilisateur de tension (28).

3. Dispositif de mesure suivant la revendication 2, caractérisé par le fait qu'une résistance de shuntage (24) est branchée en parallèle avec la diode lumineuse (12) montée en série avec le premier commutateur électronique (14).

4. Dispositif de mesure suivant la revendication 2 ou 3, caractérisé par le fait qu'une diode Zener (29) du circuit de stabilisation (28) est branchée en série avec la résistance de détection (3) et que le point (31), situé à l'opposé de la résistance de détection (3), de raccordement de la diode Zener (29) est relié par l'intermédiaire d'une résistance variable (32) à la borne d'entrée (7) du multivibrateur (9), qui est raccordé au point, situé à l'opposé de la diode Zener (29), de raccordement de la résistance de détection (3).

5. Dispositif de mesure servant à réaliser le réglage précis du début de la plage de mesure, déterminé par une valeur en courant continu prédéterminée, d'un convertisseur de mesure du type à deux conducteurs, caractérisé en ce qu'à une résistance de détection branchée en série avec le convertisseur de mesure, se trouve raccordée une entrée d'un dispositif à amplificateurs différentiels dont les deux amplificateurs différentiels fonctionnent en push-pull et qu'en aval du dispositif à amplificateurs différentiels se trouve branché un dispositif comportant deux diodes lumineuses qui peuvent être commandées respectivement par l'un des deux amplificateurs différentiels de telle sorte qu'elles éclairent avec une luminosté identique dans le cas d'un réglage précis du début de la plage de mesure.

6. Dispositif de mesure suivant la revendication 5, caractérisé par le fait qu'en série avec les diodes lumineuses se trouvent branchés des dispositifs électroniques respectifs de commande, dont les entrées sont reliées aux sorties des amplificateurs différentiels, et que les circuits-série formés par une diode lumineuse et un dispositif de commande électronique sont raccordés respectivement à un circuit de stabilisation.

FIG.1

0 091 397